# EUROPEAN PATENT APPLICATION

(11) **EP 4 378 739 A1**
(43) Date of publication of application: **05.06.2024**
(21) Application number: 22210944.9
(22) Date of filing: 01.12.2022
(51) Int. Cl.: B60L 3/00, G01R 31/36

(54) **ENCAPSULATION MONITORING SYSTEM**

(71) Applicant: Volvo Car Corporation, 405 31 Göteborg (SE)
(72) Inventor: ELSAYED, Waled, 40531 Göteborg (SE); KJELLGREN, Simon, 40531 Göteborg (SE)
(74) Representative: Maiwald GmbH

(57) **Abstract**

The present disclosure relates to an encapsulation monitoring system for a vehicle, a vehicle comprising such encapsulation monitoring system, an encapsulation monitoring method and a computer program element for such encapsulation monitoring system.

The encapsulation monitoring system comprises a communication element, a malfunction monitoring element, and a control unit. The communication element and the malfunction monitoring element are arrangeable on at least one subsystem of the vehicle. The subsystem is supplied by an energy storage system. The malfunction monitoring element is configured to identify an availability of a power supply if the subsystem is connected to the energy storage system. The malfunction monitoring element is configured to identify an unavailability of the power supply if the subsystem is disconnected from the energy storage system. The control unit is configured to send a status request to the communication element. The communication element is configured to send a status report in response to the status request to the control unit. The status report contains only an availability or an unavailability of the power supply.

## Description

### TECHNICAL FIELD

The present disclosure relates to an encapsulation monitoring system for a vehicle, a vehicle comprising such encapsulation monitoring system, an encapsulation monitoring method and a computer program element for such encapsulation monitoring system.

### BACKGROUND ART

Battery-powered vehicles, such as electric vehicles or hybrid electric vehicles comprise a battery system supplying a high-voltage to operate an electric motor of the vehicle. The battery system may comprise a plurality of battery cells connected in series or parallel. For a safe operation and a reliable power estimation, the battery system may be controlled by a battery monitoring system (BMS).

Generally, monitoring of an electrical encapsulation of a high voltage battery system is carried out by arranging a 12 V loop connected to all of the low voltage and high voltage connectors in series. Any failure in the electrical encapsulation of the battery system requires an action to secure a reliable integrity of the battery system and human's safety.

### SUMMARY

Hence, there may be a need to provide an improved encapsulation monitoring system, which facilitates monitoring an isolation of each individual subsystem.

The problem is at least partially solved or alleviated by the subject matter of the independent claims of the present disclosure, wherein further examples are incorporated in the dependent claims. It should be noted that the aspects of the disclosure described in the following apply to the encapsulation monitoring system for a vehicle, the vehicle comprising such encapsulation monitoring system, the encapsulation monitoring method and the computer program element for such encapsulation monitoring system.

According to the present disclosure, an encapsulation monitoring system for a vehicle is presented. The encapsulation monitoring system comprises a communication element, a malfunction monitoring element, and a control unit. The communication element and the malfunction monitoring element are arrangeable on at least one subsystem of the vehicle. The subsystem is supplied by an energy storage system. The malfunction monitoring element is configured to identify an availability of a power supply if the subsystem is connected to the energy storage system. The malfunction monitoring element is configured to identify an unavailability of the power supply if the subsystem is disconnected from the energy storage system. The control unit is configured to send a status request to the communication element. The communication element is configured to send a status report in response to the status request to the control unit. The status report contains only an availability or an unavailability of the power supply.

The encapsulation monitoring system according to the present disclosure enables an individual monitoring of one or more subsystems of the vehicle, each of which is connected to the energy storage system for an energy supply. Accordingly, a user may be able to easily find a failure location and solve the failure problem quickly with appropriate countermeasures.

The vehicle may comprise at least one, preferably several subsystems, each of which may operate as a predefined single unit to propel the vehicle or assist operating the vehicle. The subsystems of the vehicle may comprise, for instance, engine control, transmission control, brake control, suspension control, climate control, infotainment system, cabin control, etc. In a battery electric vehicle or a hybrid electric vehicle, such subsystems may be powered by the energy storage system.

The energy storage system may be a high voltage energy storage system, which provides tens of kilowatt-hours as energy for operating the vehicle. The energy storage system may comprise a plurality of rechargeable energy storage modules and/or energy storage cells such as lithium-ion cells, nickel metal hydride cells or the like.

The malfunction monitoring element may be adapted to monitor an electrical connectivity between the energy storage system and the subsystem. In other words, the malfunction monitoring unit may be adapted to assess, whether the subsystem is powered by the energy storage system or a power supply circuit between the energy storage system and the subsystem may be closed. The term "availability of a power supply" may be understood that an energy transfer is carried out between the energy storage system and the subsystem.

The malfunction monitoring element may be also adapted to monitor, whether the power supply from the energy storage system to the subsystem is disconnected. In other words, the malfunction monitoring element may be capable to assess, whether the power supply circuit between the energy storage system and the subsystem is open. Hence, the term "unavailability of the power supply" may be understood that an energy transfer is disconnected or interrupted between the energy storage system and the subsystem.

The subsystem may further comprise a communication element configured to transfer information between the subsystem and the control unit. The communication element and the control unit may comprise a wired communication link or a wireless communication link such as Wi-Fi, Bluetooth, and/or a combination thereof.

The control unit may be at least a part of an electronic control unit (ECU) for the energy storage system and/or a battery management system (BMS) configured for monitoring operational parameters associated with the energy storage system.

When the control unit identifies that the energy storage system is activated for supplying energy, the control unit may be configured to generate and transmit a request for acquiring a status of the power supply to the subsystem. Accordingly, the status request may comprise an inquiry regarding the availability of the power supply or the unavailability of the power supply to the subsystem.

Once the communication element receives the status request, the communication element may be capable to receive current state information of the power supply between the subsystem and the energy storage system from the malfunction monitoring element. Accordingly, the communication element may be adapted to transmit the status report comprising the current state information to the control unit.

The status report and/or the current state information may comprise only binary information, which is the availability of the power supply or the unavailability of the power supply to the subsystem. In other words, the status report may not comprise any qualitative or quantitative information of the power supply from the energy storage system to the subsystem. Accordingly, a quick and easy encapsulation monitoring may be achieved.

In an example, the malfunction monitoring element is a high voltage interface between the energy storage system and the subsystem. The malfunction monitoring element configured to identify the availability of the power supply or the unavailability of the power supply to the subsystem may form an interface between the energy storage system and the subsystem.

In other words, the malfunction monitoring element may be configured to detect, whether the high voltage power supply to the subsystem is connected or disconnected during the energy storage system and/or the subsystem is activated. For instance, the energy storage system may be a high voltage energy storage system adapted to supply traction energy of the vehicle and the malfunction monitoring element may be capable to monitor the high voltage power supply from the energy storage system to the respective subsystem.

In an example, the communication element is a low voltage interface between the subsystem and the control unit. The communication element may be adapted to form a communication interface between the subsystem and the control unit. Such interface may utilize a low voltage communication network to transmit information such as the status request and the status report. In other words, the communication element of the subsystem may be operated separately from the high voltage power supply such that the unavailability of the power supply from the energy storage system does not affect an operation of the communication element.

In an example, the control unit is configured to identify the unavailability of the power supply as an encapsulation failure. The control unit may be adapted to verify the encapsulation failure, in other words, electricity isolation failure, if the subsystem is disconnected from the energy storage system, although the subsystem is activated. The control unit may be capable to recognize such unavailability of the power supply and determine appropriate following steps to prevent dangerous voltages from passing to a user.

In an example, the control unit is configured to send an activation signal to the subsystem. The control unit may be adapted to initiate the communication between the subsystem and the control unit by sending the activation signal prior to the status request. Additionally or alternatively, the subsystem may be also able to send the activation signal to the control unit when activated. Accordingly, the control unit may be able to verify, whether there is any communication problem between the control unit and the subsystem.

In an example, the control unit is configured to communicate with a plurality of subsystems of the vehicle, each of which comprises an individual communication element and an individual malfunction monitoring element. In an example, the control unit is configured to communicate with the plurality of subsystems independently of each other.

Generally, the vehicle comprises several subsystems powered by the energy storage system to propel the vehicle. Each subsystem may comprise an individual malfunction monitoring element to identify an availability or an unavailability of the power supply from the energy storage system to the respective subsystem and an individual communication element to transmit information to or from the control unit.

Each malfunction monitoring element may be a high voltage interface between the energy storage system and the respective subsystem. Further, each communication monitoring element may be a low voltage interface between the subsystem and the control unit. Accordingly, the control unit may be able to communicate with each of the subsystems independently regarding the availability or the unavailability of the power supply and identify, at which subsystem the encapsulation failure occurs.

In an example, the control unit is configured to re-send the status request to the subsystem, for which unavailability of the power supply is identified. The control unit may be configured to confirm the unavailability of the power supply of the subsystem. Accordingly, once the control unit receives a status report with the unavailability of the power supply, the control unit may be adapted to send the status request again to assure the disconnection of the power supply from the energy storage system to the subsystem.

In an example, the control unit is configured to re-send the status request to the subsystem, for which no status report is received. The control unit may be also configured to repeat sending the status request, if the communication element of the subsystem does not respond to the status request sent by the control unit. No response or no status report of the subsystem may indicate an unavailability of the power supply and/or a malfunction of the communication element.

In an example, the control unit is configured to inform a user about the availability or unavailability of the power supply of the subsystem via a human-machine interface. The human-machine interface may be configured to interact with a user. The human-machine interface unit comprises at least a sound system and a display unit. The human-machine interface unit may adapt one or more user-friendly applications to facilitate communication between the user and the control unit of the vehicle. Accordingly, via the human-machine interface, the control unit may provide the user the status report graphically via the display unit and/or audibly via the sound system.

In an example, the control unit is configured to disconnect the energy storage system from all subsystems in case of the unavailability of the power supply in one of the subsystems. Once the control unit determines at least one subsystem with unavailability of the power supply, preferably after re-sending the status request, the control unit may be configured to disconnect the energy supply among the energy storage system and all subsystems to ensure safety of the vehicle.

In an example, the subsystem is one of electric rear axle drive, electric front axle drive, electrical air compressor, and high voltage air heater. The subsystem may be adapted to propel the vehicle or assist operating the vehicle. In general, the energy storage system provides electric power not only to propulsion systems such as an electric front axle drive system or an electric rear axle drive system but also to non-propulsion loads such as electrical air compressor, high voltage air heater, door/window actuation system, navigation system, sensor systems for automated driving functions, etc.

Each of such subsystems may comprise an individual malfunction monitoring element and individual communication element to facilitate the encapsulation monitoring of each subsystem. Accordingly, the control unit may be able to communicate with each of the subsystems independently about the availability or the unavailability of the power supply and identify, at which subsystem the encapsulation failure occurs.

According to the present disclosure, a vehicle is also presented. The vehicle comprises an encapsulation monitoring system as described above. The vehicle may be a battery electric vehicle (BEV) or a hybrid electric vehicle (HEV), which can be propelled by a high voltage energy storage system.

According to the present disclosure, an encapsulation monitoring method is also presented. The method comprises, not necessarily in this order,
- sending a status request to a communication element,
- identifying an availability of a power supply if a subsystem is connected to an energy storage system,
- identifying an unavailability of the power supply if the subsystem is disconnected from the energy storage system, and
- sending a status report in response to the status request to a control unit, the status report containing only an availability or an unavailability of the power supply.
The communication element and a malfunction monitoring element being arrangeable on at least one subsystem of the vehicle. The subsystem is supplied by the energy storage system.

According to the present disclosure, a computer program element is also presented. The computer program element is configured for an encapsulation monitoring system as described above. The computer program element is adapted to perform the encapsulation monitoring method steps as described above, when executed by a processing element.

According to the present disclosure, one or more computer storage media may be presented. The computer storage media is encoded with instructions, that when executed by a computer, cause the computer to perform the operations of the respective method as described above.

The storage media may comprise internal to a computing device, such as a computer's SSD, or a removable device such as an external HDD or universal serial bus (USB) flash drive. There are also other types of storage media, including magnetic tape, compact discs (CDs) and non-volatile memory (NVM) cards.

It should be noted that the above examples may be combined with each other irrespective of the aspect involved. Accordingly, the method may be combined with structural features and, likewise, the system may be combined with features described above with regard to the method.

These and other examples of the present disclosure will become apparent from and elucidated with reference to the embodiments described hereinafter.

### BRIEF DESCRIPTION OF DRAWINGS

Examples according to the present disclosure will be described in the following with reference to the following drawings.
- Fig. 1: shows schematically an example of an encapsulation monitoring system according to the present disclosure.
- Fig. 2: shows schematically an example of an encapsulation monitoring method according to the present disclosure.

### DESCRIPTION OF EXAMPLES

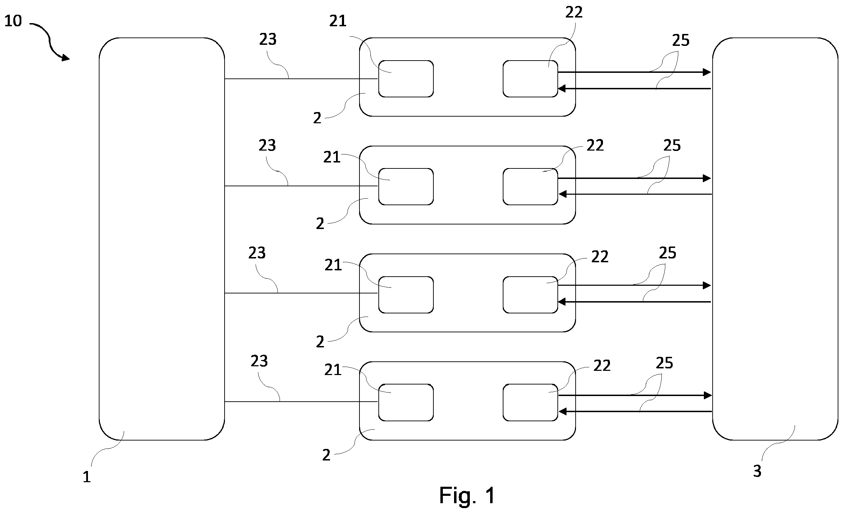

Fig. 1 shows an encapsulation monitoring system 10 for a vehicle. The vehicle may be a battery electric vehicle (BEV) or a hybrid electric vehicle (HEV), which can be propelled by a high voltage energy storage system 1. Generally, such vehicle comprises several subsystems powered by the energy storage system 1 to propel the vehicle or assist operating the vehicle. The subsystem may be, for instance, one of electric rear axle drive, electric front axle drive, electrical air compressor and high voltage air heater.

The encapsulation monitoring system 10 comprises a communication element 22, a malfunction monitoring element 21, and a control unit 3. The communication element 22 and the malfunction monitoring element 21 are arrangeable on at least one subsystem 2 of the vehicle. In other words, each of the several subsystems 2 comprises an individual communication element 22 and an individual malfunction monitoring element 21.

The malfunction monitoring element 21 is a high voltage interface between the energy storage system 1 and the respective subsystem 2. The malfunction monitoring element 21 is configured to identify an availability of a power supply 23 if the subsystem 2 is connected to the energy storage system 1. The malfunction monitoring element 21 is also configured to identify an unavailability of the power supply 23 if the subsystem 2 is disconnected from the energy storage system 1.

The communication monitoring element is a low voltage interface between the respective subsystem 2 and the control unit 3. The control unit 3 is configured to communicate with the plurality of subsystems 2 independently of each other.

The control unit 3 is configured to send a status request 25 to the communication element 22. The communication element 22 is configured to send a status report 25 in response to the status request 25 to the control unit 3. The status report 25 contains only binary information of an availability or an unavailability of the power supply 23. The control unit 3 is configured to identify the unavailability of the power supply 23 as an encapsulation failure. The control unit 3 is configured to inform a user about the unavailability of the power supply 23 of the respective subsystem 2 via a human-machine interface (not shown). The human machine interface unit may adapt one or more user-friendly applications to facilitate communication between the user and the control unit 3 of the vehicle.

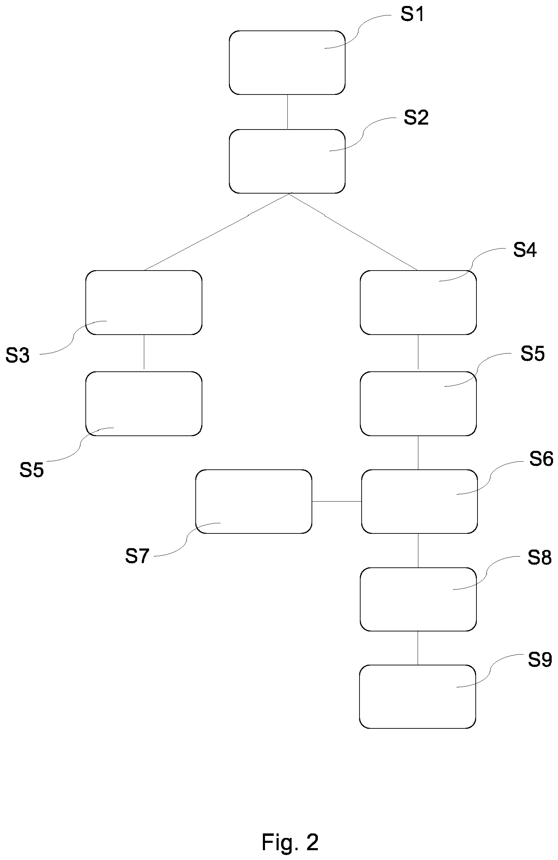

In particular, the control unit 3 is adapted to perform the encapsulation monitoring as shown in Fig. 2, but not necessarily in this order:
- S1:: sending an activation signal to each subsystem 2;
- S2:: sending a status request 25 to a communication element 22 of each subsystem;
- S3:: identifying an availability of a power supply 23, if the subsystem 2 is connected to an energy storage system 1;
- S4:: identifying an unavailability of the power supply 23, if the subsystem 2 is disconnected from the energy storage system 1;
- S5:: sending a status report 25 in response to the status request 25 to a control unit 3, the status report 25 containing only an availability or an unavailability of the power supply 23;
- S6:: resending the status request 25 to the subsystem, for which unavailability of the power supply 23 is identified;
- S7:: resending the status request 25 to the subsystem, for which no status report 25 is received;
- S8:: informing a user about the unavailability of the power supply 23 of the subsystem 2 via a human-machine interface;
- S9:: deactivating the subsystem 2 with the unavailability of the power supply 23.

It has to be noted that examples of the disclosure are described with reference to different subject matters. In particular, some examples are described with reference to method type claims whereas other examples are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the disclosure has been illustrated and described in detail in the drawings and description, such illustration and description are to be considered illustrative or exemplary and not restrictive. The disclosure is not limited to the disclosed examples. Other variations to the disclosed examples can be understood and effected by those skilled in the art in practicing a claimed disclosure, from a study of the drawings, the disclosure, and the dependent claims.

In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

## Claims

1. An encapsulation monitoring system (10) for a vehicle, comprising,
- a communication element (22),
- a malfunction monitoring element (21), and
- a control unit (3),
the communication element (22) and the malfunction monitoring element (21) being arrangeable on at least one subsystem (2) of the vehicle, the subsystem (2) being supplied by an energy storage system (1),
the malfunction monitoring element (21) being configured to identify an availability of a power supply (23) if the subsystem (2) is connected to the energy storage system (1),
the malfunction monitoring element (21) being configured to identify an unavailability of the power supply (23) if the subsystem (2) is disconnected from the energy storage system (1),
the control unit (3) being configured to send a status request (25) to the communication element (22),
the communication element (22) being configured to send a status report (25) in response to the status request (25) to the control unit (3), and
the status report (25) containing only an availability or an unavailability of the power supply (23).

2. The encapsulation monitoring system (10) according to claim 1, the malfunction monitoring element (21) being a high voltage interface between the energy storage system (1) and the subsystem (2).

3. The encapsulation monitoring system (10) according to claim 1, the communication element (22) being a low voltage interface between the subsystem (2) and the control unit (3).

4. The encapsulation monitoring system (10) according to any of the preceding claims, the control unit (3) being configured to identify the unavailability of the power supply (23) as an encapsulation failure.

5. The encapsulation monitoring system (10) according to any of the preceding claims, the control unit (3) being configured to send an activation signal to the subsystem (2).

6. The encapsulation monitoring system (10) according to any of the preceding claims, the control unit (3) being configured to communicate with a plurality of subsystems (2) of the vehicle, each of which comprising an individual communication element (22) and an individual malfunction monitoring element (21).

7. The encapsulation monitoring system (10) according to the preceding claim, the control unit (3) being configured to communicate with the plurality of subsystems (2) independently of each other.

8. The encapsulation monitoring system (10) according to any of the preceding claims, the control unit (3) being configured to re-send the status request (25) to the subsystem, for which unavailability of the power supply (23) is identified.

9. The encapsulation monitoring system (10) according to any of the preceding claims, the control unit (3) being configured to re-send the status request (25) to the subsystem, for which no status report (25) is received.

10. The encapsulation monitoring system (10) according to any of the preceding claims, the control unit (3) being configured to inform a user about the availability or unavailability of the power supply (23) of the subsystem (2) via a human-machine interface.

11. The encapsulation monitoring system (10) according to any of the preceding claims, the control unit (3) being configured to disconnect the energy storage system (1) from all subsystems (2) in case of the unavailability of the power supply (23) in at least one subsystem (2).

12. The encapsulation monitoring system (10) according to any of the preceding claims, the subsystem (2) being one of electric rear axle drive, electric front axle drive, electrical air compressor and high voltage air heater.

13. A vehicle, the vehicle comprising an encapsulation monitoring system (10) according to any of the preceding claims 1 to 12.

14. An encapsulation monitoring method for a vehicle, the method comprising,
- sending (S2) a status request (25) to a communication element (22), and
- identifying (S3) an availability of a power supply (23) if a subsystem (2) is connected to an energy storage system (1),
- identifying (S4) an unavailability of the power supply (23) if the subsystem (2) is disconnected from the energy storage system (1), and
- sending (S5) a status report (25) in response to the status request (25) to a control unit (3), the status report (25) containing only an availability or an unavailability of the power supply (23),
the communication element (22) and a malfunction monitoring element (21) being arrangeable on at least one subsystem (2) of the vehicle, the subsystem (2) being supplied by the energy storage system (1).

15. A computer program element for an encapsulation monitoring system (10) according to any of the preceding claims 1 to 12, which, when being executed by a processing element, is adapted to perform the method steps according to claim 14.

## Amended claims

### Amended claims in accordance with Rule 137(2) EPC.

1. An encapsulation monitoring system (10) for a vehicle, comprising,
- a communication element (22),
- a malfunction monitoring element (21), and
- a control unit (3),
the communication element (22) and the malfunction monitoring element (21) being arrangeable on at least one subsystem (2) of the vehicle, the subsystem (2) being supplied by an energy storage system (1),
the malfunction monitoring element (21) being configured to identify an availability of a power supply (23) if the subsystem (2) is connected to the energy storage system (1),
the malfunction monitoring element (21) being configured to identify an unavailability of the power supply (23) if the subsystem (2) is disconnected from the energy storage system (1),
the control unit (3) being configured to send a status request (25) to the communication element (22),
the communication element (22) being configured to send a status report (25) in response to the status request (25) to the control unit (3), and
the status report (25) containing only an availability or an unavailability of the power supply (23),
the control unit (3) being configured to communicate with a plurality of subsystems (2) of the vehicle, each of which comprising an individual communication element (22) and an individual malfunction monitoring element (21),
the subsystem (2) being one of electric rear axle drive, electric front axle drive, electrical air compressor and high voltage air heater.

2. The encapsulation monitoring system (10) according to claim 1, the communication element (22) being a low voltage interface between the subsystem (2) and the control unit (3).

3. The encapsulation monitoring system (10) according to any of the preceding claims, the control unit (3) being configured to identify the unavailability of the power supply (23) as an electricity isolation failure.

4. The encapsulation monitoring system (10) according to any of the preceding claims, the control unit (3) being configured to send an activation signal to the subsystem (2).

5. The encapsulation monitoring system (10) according to the preceding claim, the control unit (3) being configured to communicate with the plurality of subsystems (2) independently of each other.

6. The encapsulation monitoring system (10) according to any of the preceding claims, the control unit (3) being configured to re-send the status request (25) to the subsystem, for which unavailability of the power supply (23) is identified.

7. The encapsulation monitoring system (10) according to any of the preceding claims, the control unit (3) being configured to re-send the status request (25) to the subsystem, for which no status report (25) is received.

8. The encapsulation monitoring system (10) according to any of the preceding claims, the control unit (3) being configured to inform a user about the availability or unavailability of the power supply (23) of the subsystem (2) via a human-machine interface.

9. The encapsulation monitoring system (10) according to any of the preceding claims, the control unit (3) being configured to disconnect the energy storage system (1) from all subsystems (2) in case of the unavailability of the power supply (23) in at least one subsystem (2).

10. A vehicle, the vehicle comprising an encapsulation monitoring system (10) according to any of the preceding claims 1 to 9.

11. An encapsulation monitoring method for a vehicle, the method comprising,
- sending (S2) a status request (25) to a communication element (22), and
- identifying (S3) an availability of a power supply (23) if a subsystem (2) is connected to an energy storage system (1),
- identifying (S4) an unavailability of the power supply (23) if the subsystem (2) is disconnected from the energy storage system (1), and
- sending (S5) a status report (25) in response to the status request (25) to a control unit (3), the status report (25) containing only an availability or an unavailability of the power supply (23),
the communication element (22) and a malfunction monitoring element (21) being arrangeable on at least one subsystem (2) of the vehicle, the subsystem (2) being supplied by the energy storage system (1)
the control unit (3) being configured to communicate with a plurality of subsystems (2) of the vehicle, each of which comprising an individual communication element (22) and an individual malfunction monitoring element (21),
the subsystem (2) being one of electric rear axle drive, electric front axle drive, electrical air compressor and high voltage air heater.

12. A computer program element for an encapsulation monitoring system (10) according to any of the preceding claims 1 to 9, which, when being executed by a processing element, is adapted to perform the method steps according to claim 11.
